# EUROPEAN PATENT APPLICATION

(11) **EP 1 035 561 A2**
(43) Date of publication of application: **13.09.2000**
(21) Application number: 00301563.3
(22) Date of filing: 28.02.2000
(51) Int. Cl.: H01J 37/32

(54) **Refractory coated component for use in thin film deposition and method for making**

(30) Priority: 02.03.1999 US 260300
(71) Applicant: Praxair S.T. Technology, Inc., North Haven, CT 06473 (US)
(72) Inventor: Lam,Raymond K.F., Park Ridge, New Jersey 07656 (US); Gilman,Paul S., Suffern, New York 10901 (US); Lo,Chi-Fung, Fort Lee, New Jersey 07024 (US)
(74) Representative: Findlay, Alice Rosemary

(57) **Abstract**

An induction coil (16) and method of manufacturing is provided for refractory or dielectric material coated thin coils for use in ionized metal plasma or plasma-enhanced physical vapor thin film deposition. A coil substrate made of a plastic metal that is easily formed into a coil shape is coated, preferably by a thermal spray technique, with a material substantially identical to the material to be deposited as the thin film to prevent film contamination. Similarly, a method of manufacturing is provided for refractory or dielectric material coated showerheads for use is plasma-enhanced chemical vapor thin film deposition.

## Description

This invention relates to refractory coated induction coils and showerheads for use in physical and chemical vapor deposition of thin film coatings on semiconductor devices, and a method of fabricating them.

Ionized metal plasma (IMP) physical vapor deposition (PVD) is gaining popularity as a thin film deposition technique. Compared to conventional PVD techniques, IMP provides a better interconnect line and via filling in semiconductor device metallization. By placing an induction coil between the sputter target and the semiconductor wafer onto which the thin film is to be deposited, the metal atoms dislodged from the sputter target surface by ion bombardment will be ionized prior to being deposited onto the bias wafer.

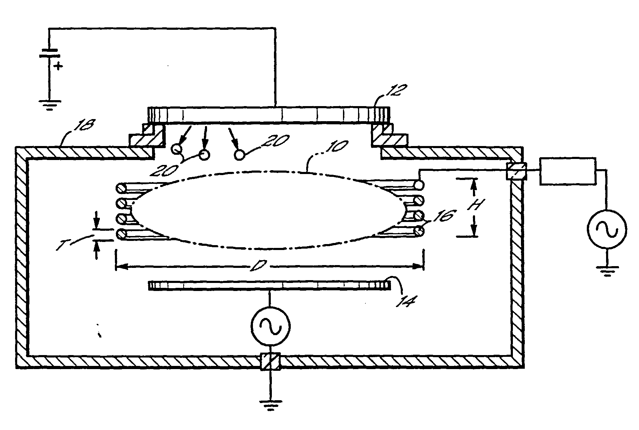

As shown in the Figure, the inductively coupled Ar plasma 10 is created between the target 12 and the semiconductor wafer 14 by applying radio frequency (RF) power to a coil 16 within the process chamber 18. The ionized metal atoms 20 are then directed toward the wafer 14 by the difference between the plasma potential (∼ 20V) and the wafer floating potential (∼ -2V). To prevent contamination of the thin film, this induction coil is required to be the same material as the deposited film material. For the refractory materials normally used as conducting plug and diffusion barrier, such as tungsten and tantalum, formation of a coil is difficult, especially for some equipment designs in which the induction coil is as thin as 0.0625 inch with an 11-inch diameter and 2-inch width. Thus, it is difficult to make induction coils for IMP PVD apparatuses when the thin film to be deposited is for conducting vias and diffusion barriers. Manufacture of these induction coils has proven to be an expensive and lengthy process. Furthermore, the induction coil is eroded during the deposition process and simultaneously coated with target material. As a result, the induction coils must typically be replaced every two targets. Similar problems exist for induction coils used in plasma-enhanced PVD (PEPVD) and showerheads/electrodes used in plasma-enhanced chemical vapor deposition (PECVD), for example. In PECVD, the showerhead is biased with RF energy such that it acts as an electrode to excite a plasma proximate with the wafer. In any CVD or PVD process in which a component is present in the deposition chamber in the path of an RF field, that component could contribute to contamination of the thin film deposited.

U.S. Patent No. 5,707,498 describes one technique for providing induction coils, wherein an in situ pasting or coating process is carried out within the deposition chamber. The RF power to the induction coil is turned off, and a "dummy" wafer is coated by physical vapor deposition. During this pasting process, the target is sputtered, and target material is coated onto those coil surfaces exposed to the ionized target particles. The "dummy" wafer is then replaced with the actual wafer, the RF power to the coil is turned on, and the film deposition process begun. This process can be repeated upon erosion of the coil coating.

One disadvantage to this in situ pasting process is that for a certain number of wafer depositions, the process requires an equivalent time for pasting to ensure that the original coil material will not become exposed during the sputtering process. Thus, the process time to deposit the given number of wafers is doubled. Additional disadvantages include a very thin coating, typically on the order of thousands of angstroms, and no more than a few hundred micrometers; only part of the coil being coated, leaving the rest exposed to potentially contribute to contamination; and a smooth coating surface with insufficient surface roughness to avoid flaking during the subsequent deposition.

It is an object of the invention to provide a more economical and time efficient method for producing induction coils, showerheads, and other components used in ionized and plasma-enhanced CVD and PVD apparatuses.

The present invention provides a method of coating thin coils, showerheads, and other components used in ionized metal plasma and plasma-enhanced thin film deposition. An electrically conductive coil-shaped core or showerhead is coated, preferably by a thermal spray technique, with a refractory or dialectric material substantially identical to the material to be vapor deposited as a thin film. The thermal spray technique, or alternatively sputtering, electroplating or chemical vapor deposition, is useful in coating thin coils which have a complicated shape, and are therefore preferably made of a formable material, such as plastic metals.

The invention will now be further described by way of example with reference to the Figure which is a diagrammatical depiction of an ionized metal plasma deposition apparatus and method.

The present invention employs thermal spray techniques or similar techniques to manufacture induction coils used in IMP PVD and PEPVD apparatuses, showerheads used in PECVD, and any other component in these apparatuses that may contribute to contamination of the thin film. To this end and in accordance with the principles of the present invention, an electrically conductive core of a formable material, such as a thin plastic metal, is formed into the desired coil shape or showerhead and coated with a refractory or dialectic material substantially identical to the material to be deposited as a thin film. The present invention provides a simple and cost effective means for manufacturing induction coils placed between the sputter target and the semiconductor wafer to ionize the metal atoms dislodged from the target before being deposited onto the wafer such that no contamination of the thin film occurs from the induction coil. The present invention further provides a simple means for coating showerheads used in PECVD for delivering the plasma and reacting gases for depositing thin films such that no contamination from the showerhead occurs.

In one exemplary embodiment, the thermal spray coatings are produced from either wire or powder materials that are melted into droplets, then propelled onto the coil or showerhead substrate. Upon impact, the droplets form platelets that bond to the surface, creating a dense coating with no alteration to the substrate structure. Useful thermal spray techniques include plasma spray, flame spray, high velocity oxygen fuel spray, and electric arc spray. Low pressure plasma spray (LPPS), also known as vacuum plasma spray (VPS), is a plasma spray technique conducted in a vacuum chamber evacuated to below 10 Torr. The plasma spray is achieved using heat transfer from a high-kilowatt electric arc to a plasma-forming gas directed through flow enhancing nozzles. The plasma gun comprises a copper anode and tungsten cathode, both of which are water cooled. Within the spray device, the gas flow chamber contains an axial stick cathode adjacent to the nozzle, which forms a ring anode. Plasma gas of argon, nitrogen, hydrogen, or helium flows around the cathode and through the anode which is shaped as a constricting nozzle. The plasma is initiated by a high voltage discharge that causes localized ionization and a conductive path for a direct-current arc to form between cathode and anode. The resistance heating from the arc causes the gas to reach extreme temperatures, higher than 10,000°F, disassociate and ionize to form a plasma. The plasma exits the anode nozzle as the free or neutral plasma flame, in other words, plasma that does not carry an electric current. Powder is fed into the plasma flame via an external powder port mounted near the anode nozzle exit. It melts in the hot gas and is propelled at high velocity to the coil surface. The high velocity of the spray plume creates dense coatings by propelling molten metal droplets to the coil or showerhead substrate at a speed exceeding mach two. This process is a dust-free and environmentally clean operation due to the process being contained in a vacuum chamber. This vacuum environment permits reclaiming of powders. LPPS provides a dense, pore-free coating, typically 99% of theoretical density. Furthermore, the coating is oxide-free and of high purity. Preheating the substrate to high temperatures will further produce coatings with low thermal stresses, which allows for thick coatings. Cleaning the substrate prior to coating will also contribute to the oxide-free, clean metallurgical bond between the coating and substrate. Thus, LPPS is particularly suitable for the method due to the high purity, low oxide contamination, high bond strength and high density characteristics of the coatings.

Additional techniques for coating refractory and dialectric materials to the coil-shaped core and showerhead substrates include sputtering, electroplating and chemical vapor deposition. The induction coils and showerheads are coated prior to placement in the chamber for thin film deposition, so the film deposition process is not lengthened as in prior in situ coating methods.

Refractory materials, such as tungsten, tantalum, cobalt, titanium, molybdenum, platinum, chromium, niobium, nickel and alloys thereof or dielectric materials, such as tungsten silicon nitride, tantalum oxide and silicon carbide, are coated onto formable plastic metals, such as copper, aluminium, titanium, steel and other metallic materials that are easily formed to the desired coil shape or onto typical materials used for showerheads, such as nickel alloys. The coating material should be the same as the material to be deposited as a thin film, to avoid contamination of the thin film. High purity refractory and dielectric materials are used to further prevent contamination. The coating is applied to all surfaces of the coil or showerhead such that no uncoated surface is exposed that could potentially contaminate the thin film.

The thermal spray or similar techniques described above are useful for preparing induction coils, as shown in the Figure, having thicknesses T of about 0.05 inch to about 0.5 inch, diameters D of about 1.0 inch to about 30.0 inches, and heights H of about 0.5 inch to about 4.0 inches. The coating is preferably applied to a thickness of about 0.01 inch to about 0.3 inch. The greater thickness of the coating compared to coatings applied by previous methods allows the induction coil to be used for a greater number of wafers before the coil must be replaced or re-coated. The coated thin coils are easy to manufacture, and at lower costs and shorter production time than prior methods. The thermal spray coating further provides the desired high surface roughness for induction coils to prevent flaking off of the coating during deposition.

While the present invention has been illustrated by the description of an embodiment thereof, and while the embodiment has been described in considerable detail, additional advantages and modifications will readily appear to those skilled in the art.

## Claims

1. A method of making a coated component positionable in a deposition chamber for creating a plasma therein to assist in deposition of a predetermined material onto a wafer, comprising the steps of forming an electrically conductive core fabricated of a material different than said predetermined material which will fit inside the deposition chamber, and spray coating the core with a material substantially identical to the predetermined material prior to positioning inside the deposition chamber.

2. The method of Claim 1, wherein the component is an induction coil positionable in a physical vapour deposition chamber and the core is formed in a coil shape.

3. The method of Claim 2, wherein the coil-shaped core has a thickness of about 0.05 inch to about 0.5 inch, a diameter of about 1.0 inch to about 30.0 inches, and a height of about 0.5 inch to about 4.0 inches.

4. The method of Claim 1, wherein the component is a showerhead positionable in a chemical vapour deposition chamber and the core is formed as a showerhead substrate.

5. The method of any preceding claim, wherein the coating comprises a refractory material selected from the group consisting of tantalum, titanium, tungsten, nickel, molybdenum, platinum, chromium, niobium, cobalt and alloys thereof.

6. The method of any one of Claims 1 to 4, wherein the coating comprises a dielectric material.

7. The method of any preceding claim, wherein the coating is applied by a method selected from the group consisting of thermal spraying, sputtering, electroplating and chemical vapour deposition.

8. The method of Claim 7, wherein the coating is applied by a thermal spray technique selected from a group consisting of plasma spray, flame spray, high velocity oxygen fuel spray, and electric arc spray.

9. The method of Claim 8, wherein the coating is applied by low pressure plasma spray.

10. The method of any preceding claim, wherein the coil-shaped core comprises a plastic metal.

11. The method of Claim 10, wherein the plastic metal is a metal selected from the group consisting of copper, aluminium, titanium, steel and alloys thereof.

12. The method of any preceding claim, wherein the coating is applied to a thickness of about 0.01 inch to about 0.3 inch.

13. A method of plasma sputter coating a wafer from a target of a predetermined material, comprising the steps of positioning in a sputter deposition chamber a target of a predetermined material; positioning a wafer in the sputter deposition chamber in spaced relation from the target; positioning in the sputter deposition chamber an induction coil having an electrically conductive core of a formable material different than the target material and a coating on the core of a material substantially identical to the target material; and energizing the induction coil to create a plasma in the chamber and sputter depositing material from the target onto the wafer.

14. An induction coil positionable in a sputter deposition chamber for creating a plasma therein to assist in deposition from a target of a predetermined material, comprising an electrically conductive core of a formable material different than the target material, the core being shaped in the form of an induction coil positionable in a sputter deposition chamber and having a thickness of about 0.05 to about 0.5 inch, a diameter of about 1.0 inch to about 30.0 inches, and a height of about 0.5 inch to about 4.0 inches, and a coating on the core comprising a material substantially identical to the target material and having a thickness of about 0.01 inch to about 0.3 inch.

15. The induction coil of Claim 14, wherein the electrically conductive core comprises a plastic metal selected from the group consisting of copper, aluminium, titanium, steel and alloys thereof.

16. The induction coil of either Claim 14 or Claim 15, wherein the coating comprises a refractory material selected from the group consisting of tantalum, titanium, tungsten, nickel, molybdenum, platinum, chromium, niobium, cobalt and alloys thereof.

17. The induction coil of any one of Claims 14 to 16, wherein the coating comprises a dielectric material.

18. An apparatus for plasma sputter coating a wafer from a target of a predetermined material, comprising a sputter deposition chamber, a target of a predetermined material in the chamber, a wafer in the chamber in spaced relation from the target, an induction coil in the chamber having an electrically conductive coil-shaped core of a formable material different than the target material and a coating on the core of a material substantially identical to the target material, and a power source connected to the induction coil for energizing the induction coil to create a plasma in the chamber for sputter depositing material from the target onto the wafer.
